# EUROPEAN PATENT APPLICATION

(11) **EP 1 014 113 A2**
(43) Date of publication of application: **28.06.2000**
(21) Application number: 99204414.9
(22) Date of filing: 20.12.1999
(51) Int. Cl.: G02B 1/04

(54) **Photo curable resin composition and optical parts**

(30) Priority: 21.12.1998 JP 36226198
(71) Applicant: DSM N.V., 6411 TE Heerlen (NL); JSR Corporation, Tokyo 104-8410 (JP); Japan Fine Coatings Co., Ltd., Tokyo 104-8410 (JP)
(72) Inventor: Takase, Hideaki, Kingston, ON K7L 5M2 (CA); Takahashi, Atsuya, Tsuchiuri-shi, Ibaraki 300-1216 (JP); Tanabe, Takayoshi, Ibaraki 305-0045 (JP); Ukachi, Takashi, Ushiku 300-12 (JP)
(74) Representative: den Hartog, Jeroen Hendrikus Joseph

(57) **Abstract**

A photo curable resin composition useful for fabricating optical parts such as a backlight for liquid crystal displays.

A photo curable resin composition comprising, (A) a compound shown by the following formula (1), 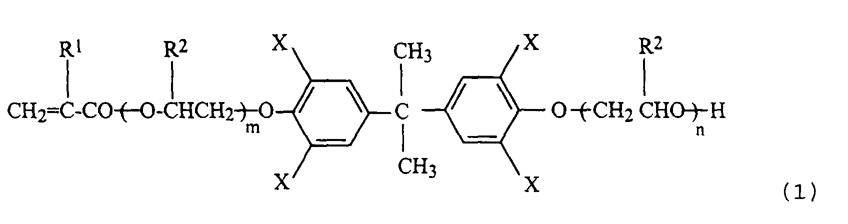 wherein R¹ and R² individually represent a hydrogen atom or methyl group, m and n are integers of which the total is 0 or 1-6, and X represents a bromine or chlorine atom, or a urethane (meth)acrylate obtained by the reaction of the compound of the formula (1) and an organic isocyanate,
(B) a (meth)acrylate which possesses 3 or more (meth)acryloyl groups in the molecule, and (C) a photopolymerization initiator; and optical parts made from the photo curable resin composition.

## Description

### Field of the Invention

The present invention relates to a photo curable resin composition useful for fabricating optical parts. More particularly, the present invention relates to a photo curable resin composition useful for fabricating optical parts, for example, lens parts such as prism lens sheets used for backlighting liquid crystal displays, Fresnel lens sheet used for screens of projection TVs, and lenticular lens sheets, as well as backlights using such sheets.

### [Prior Art]

In recent years, there have been problems relating to large electric power consumption and extended operating time in notebook-type personal computers and TVs equipped with a liquid crystal display (LCD). In particular, backlights in LCDs consume a large amount of power. To maintain high brightness of the backlight while suppressing the power consumption, a technology of placing a lens sheet in which lines of prisms are arranged between a light guide and a liquid crystal panel device has been proposed. In this instance, a material exhibiting high transparency, a high refractive index, and excellent light dispersion characteristics (a small Abbe's number) must be used for lens sheets. As such a material used for lens sheets, liquid curable resins which are curable by heat and/or radioactive rays have been developed in recent years. A lens sheet structure with lines of prism made from a cured liquid resin arranged on a plastic substrate is being studied.

### Problems to be Solved by the Invention

However, it is very difficult to develop a liquid curable resin with improved refractive index and optical dispersion characteristics, while maintaining various other characteristics required for optical materials. In particular, a resin producing cured products having a high refractive index, while exhibiting high mechanical strength, high tenacity, and excellent surface hardness over a wide temperature range is desired. It is essential for such a resin to maintain superior optical and mechanical characteristics over a long period of time. Other characteristics desired for such a resin composition include low viscosity and high adhesive properties with plastic substrates to improve processability and coatability. Moreover, because conventional lens materials have a problem of a decrease in the face brightness when exposed to a high temperature due to deformation of the prism shape or the like, providing these materials with adequate strength at high temperatures is an important technological subject.

Therefore, an object of the present invention is to provide a photo curable resin composition having a low viscosity, capable of producing cured products with a high refractive index, superior transparency, and high strength at high temperatures, and exhibiting a property of excellent adhesiveness to substrates, and further to provide optical parts which are produced by curing this composition.

### Means for Solving the Problems

The present inventors have conducted extensive studies to overcome the problems with conventional lens sheets. As a result, the inventors have found that a lens sheet and backlight having a high refractive index, superior transparency, and well-balanced strength at high temperatures, exhibiting excellent coatability during fabrication, and exhibiting superb face brightness can be obtained using a photo curable resin composition comprising a (meth)acrylate having a specific structure. This finding has led to the completion of the present invention.

Specifically, the present invention provides a photo curable resin composition comprising,
(A) a compound shown by the following formula (1), 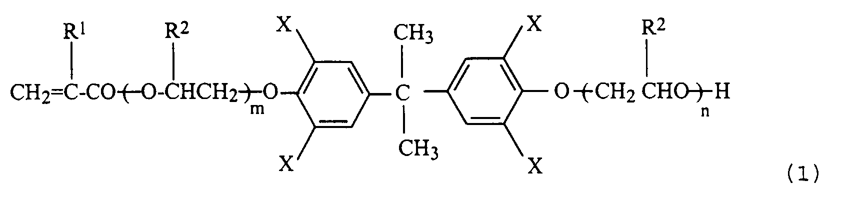 wherein R¹ and R² individually represent a hydrogen atom or a methyl group, m and n are integers of which the total of (m+n) is 0 or 1-6, and X represents a bromine or a chlorine atom, or a urethane (meth)acrylate obtained by the reaction of the compound of the formula (1) and an organic isocyanate,
(B) a (meth)acrylate which possesses 3 or more (meth)acryloyl groups in the molecule, and (C) a photopolymerization initiator.

The present invention further provides an optical part made from a cured product of the photo curable resin composition.

The photo curable resin composition of the present invention has a low viscosity which provides ease in handling and excellent coatability, and by irradiation with radioactive rays produces cured products with a high refractive index, superior transparency, and high mechanical strength at high temperatures. The products are thus useful as optical parts such as lens sheets.

### Preferred Embodiment of the Invention

The component (A) used in photo curable resin composition of the present invention is a compound shown by the above-mentioned formula (1), or a urethane (meth)acrylate obtained by reacting the compound of the formula (1) and an organic isocyanate. In the formula (1), m and n are the integers of which the total of (m+n) is 0 or 1-6, preferably 0 or 1-4, and more preferably 2. A hydrogen atom is desirable as R¹ and R². A bromine atom is desirable as X. An ideal compound is that having a hydrogen atom for R¹ and R², a bromine atom for X, and the total for m and n of 2 in the formula (1). GX-8529 (manufactured by Daiichi Kogyo Seiyaku Co., Ltd.) is given as a commercially available product. A diisocyanate is preferable as the organic isocyanate reacted with the compound of the formula (1). Given as specific examples of such a diisocyanate are 2,4-tolylene diisocyanate, 2.6-tolylene diisocyanate, 1,3-xylylene diisocyanate, 1,4-xylylene diisocyanate, 1,5-naphthalene diisocyanate, m-phenylene diisocyanate, p-phenylene diisocyanate, 3,3'-dimethyl-4,4'-diphenylmethane diisocyanate, 4,4'-diphenylmethane diisocyanate, 3,3'-dimethylphenylene diisocyanate, 4,4'-biphenylene diisocyanate. Among these, 2,4-tolylene diisocyanate, 2,6-tolylene diisocyanate, 1,3-xylylene diisocyanate, and 1,4-xylylene diisocyanate are particularly preferred. In the reaction of the compound of the formula (1) and the organic isocyanate, the compound formula (1) and the organic isocyanate are usually fed to the reactor altogether and reacted at a reaction temperature from 10 to 90°C, preferably from 30 to 80°C, usually in the presence of a urethanization catalyst such as copper naphthenate, cobalt naphthenate, zinc naphthenate, di-n-butyl tin dilaurate, triethylamine, or triethylenediamine-2-methyltriethyleneamine in an amount of 0.01 to 1 wt% for the total amount of the reactants. In this instance, the compound of the formula (1) and the organic isocyanate are used at a molar ratio of 1:0.3-1.0, preferably of 1:0.5. It is desirable that the component (A) be incorporated in the composition in an amount of 3 to 75 wt%, and preferably 10 to 65 wt%. If the amount of the component (A) is less than 3 wt%, not only can the cured products with a high refractive index not be obtained, but also the mechanical strength and tenacity of the cured products tend to be impaired. If more than 75 wt%, the viscosity of the composition increases, resulting in impaired processability and coatability.

As the (meth)acrylate having three or more (meth)acryloyl groups in the molecule used as the component (B), compounds made by an ester bond of a polyhydric alcohol possessing three or more hydroxyl groups and (meth)acrylic acid, for example, trimethylolpropane tri(meth)acrylate, pentaerythritol tri(meth)acrylate, trimethylolpropane trioxyethyl (meth)acrylate, tris(2-hydroxyethyl) isocyanurate tri(meth)acrylate, dipentaerythritol hexa(meth)acrylate can be given. As examples of commercially available products of the component (B), Viscoat #295, #300, #360, GPT, 3PA, #400 (manufactured by Osaka Organic Chemical Industry, Ltd.), Light Acrylate TMP-A, PE-3A, PE-4A, DPE-6A (manufactured by Kyoeisha Chemical Co., Ltd.), KAYARAD PET-30, GPO-303, TMPTA, DPHA, D-310, D-330, DPCA-20, DPCA-30, DPCA-60, DPCA-120 (manufactured by Nippon Kayaku Co., Ltd.), and Aronix M305, M309, M310, M315, M325, M400 (manufactured by Toagosei Co., Ltd.) can be given.

It is desirable to incorporate the component (B) in the composition in an amount of 5-40 wt%, and preferably 10-35 wt%. If less than 5 wt%, it is difficult to increase the glass-transition temperature of the system and the products tend to produce problems in mechanical properties at high temperatures. If more than 40 wt%, it is difficult to produce a cured product with a high refractive index, which results in difficulty in ensuring high brightness when the product is used as a lens sheet. To provide the cured product made from the photo curable resin composition of the present invention with a higher refractive index, which is a particularly preferable property for optical parts, it is desirable to further add a monofunctional (meth)acrylate (component (D)) shown by the following formula (2), 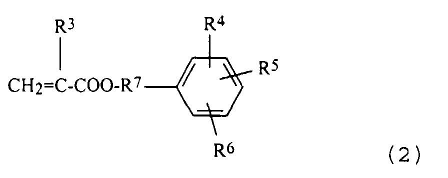 (wherein R³ represents a hydrogen atom or methyl group, R⁴-R⁶ individually represent a hydrogen atom, a bromine atom, an alkyl group having 1-10 carbon atoms, a phenyl group, or a group C₆H₅-C(CH₃)₂-, R⁷ represents a group (CH₂CH₂O)ₚ-, -(CH(CH₃)CH₂O)_{q}-, or -CH₂CH(OH)CH₂O- (wherein p and q are individually an integer of 1-10)).
As examples of the compound of the formula (2), phenoxyethyl (meth)acrylate, phenoxy-2-methylethyl (meth)acrylate, phenoxyethoxyethyl (meth)acrylate, 3-phenoxy-2-hydroxypropyl (meth)acrylate, 2-phenylphenoxy ethyl (meth)acrylate, 4-phenylphenoxy ethyl(meth)acrylate, 3-(2-phenylphenyl)-2-hydroxypropyl (meth)acrylate, (meth)acrylate of p-cumylphenol obtained by reacting ethylene oxide, 2-bromophenoxyethyl (meth)acrylate, 2,4-dibromophenoxyethyl (meth)acrylate, 2,4,6-tribromophenoxyethyl (meth)acrylate can be given. Of these, phenoxyethyl (meth)acrylate, (meth)acrylate of p-cumylphenol obtained by reacting ethylene oxide, 2,4,6-tribromophenoxyethyl (meth)acrylate are particularly preferred.

As commercially available products of these compounds, Aronix M110, M101, M5700, TO-1317 (manufactured by Toagosei Co., Ltd.), Viscoat #192, #193, #220, 3BM (manufactured by Osaka Organic Chemical Industry, Ltd.), NK Ester AMP-10G, AMP-20G (manufactured by Shin-Nakamura Chemical Co., Ltd.), Light Acrylate PO-A, P-200A, Epoxy Ester M-600A (manufactured by Kyoeisha Chemical Co., Ltd.), and PHE, CEA, PHE-2, BR-31, BR-31M and BR-32 (manufactured by Daiichi Kogyoseiyaku Co., Ltd.) can be given.

To ensure both the high refractive index and excellent coatability, as well as sufficient mechanical properties, the component (D) should be incorporated preferably in an amount of 25-60 wt%, and particularly preferably 30-55 wt%, in the composition. Compounds having a (meth)acryloyl group or vinyl group (hereinafter called "unsaturation monomer") other than the above-mentioned components (A), (B), or (D), can be used in the present invention as an optional component.

Monofunctional monomers and polyfunctional monomers can be used as such unsaturation monomers. Given as examples of monofunctional monomers are vinyl monomers such as N-vinyl pyrrolidone, N-vinyl caprolactam, vinyl imidazole, and vinylpyridine; isobornyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, benzyl (meth)acrylate, 4-butylcyclohexyl (meth)acrylate, acryloylmorpholine, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, isoamyl (meth)acrylate, hexyl (meth)acrylate, heptyl (meth)acrylate, octyl (meth)acrylate, iso-octyl (meth)acrylate, 2-ethylhexyl (meth)acrylate, nonyl (meth)acrylate, decyl (meth)acrylate, iso-decyl (meth)acrylate, undecyl (meth)acrylate, dodecyl (meth)acrylate, lauryl (meth)acrylate, stearyl (meth)acrylate, iso-stearyl (meth)acrylate, tetrahydrofurfuryl (meth)acrylate, butoxyethyl (meth)acrylate, ethoxydiethylene glycol (meth)acrylate, polyethylene glycol mono(meth)acrylate, polypropylene glycol mono(meth)acrylate, methoxy ethylene glycol (meth)acrylate, ethoxyethyl (meth)acrylate, methoxypolyethylene glycol (meth)acrylate, methoxypolypropylene glycol (meth)acrylate, diacetone (meth)acrylamide, isobutoxymethyl (meth)acrylamide, N,N-dimethyl (meth)acrylamide, t-octyl (meth)acrylamide, dimethylaminoethyl (meth)acrylate, diethylaminoethyl (meth)acrylate, 7-amino-3,7-dimethyloctyl (meth)acrylate, N,N-diethyl (meth)acrylamide, N,N-dimethylaminopropyl (meth)acrylamide, hydroxybutyl vinyl ether, lauryl vinyl ether, cetyl vinyl ether, 2-ethylhexyl vinyl ether, and monofunctional monomers and which are shown by the following formulas (3) or (4), 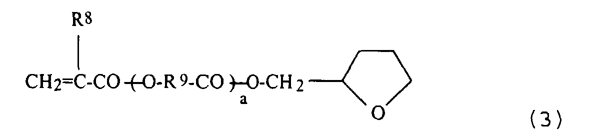 wherein R⁸ represents a hydrogen atom or a methyl group, R⁹ represents an alkylene group having 2-8, and preferably 2-5, carbon atoms, and a is an integer from 1-8, preferably 1-4, 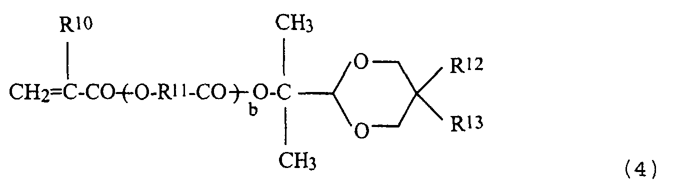 wherein R¹⁰, R¹² and R¹³ represents a hydrogen atom or a methyl group, R¹¹ represents an alkylene group having 2-8, and preferably 2-5, carbon atoms, b indicates an integer from 1-8, and preferably 1-4. As examples of commercially available products of monofunctional monomers, Aronix M111, M113, M117 (manufactured by Toagosei Co., Ltd.), LA, IBXA, Viscoat #190, #2000 (manufactured by Osaka Organic Chemical Industry, Ltd.), Light Acrylate EC-A, PO-A, NP-4EA, NP-8EA, HOA-MPL (manufactured by Kyoeisha Chemical Co., Ltd.), KAYARAD TC110S, R629, R644 (manufactured by Nippon Kayaku Co., Ltd.), FA-511A, 512A, 513A (manufactured by Hitachi Chemical Co., Ltd.), VP (manufactured by BASF), and ACMO, DMAA, DMAPAA (manufactured by Kojin Co., Ltd.), can be given.

As example as polyfunctional monomers other than the component (A), (B), or (D), ethylene glycol di(meth)acrylate, tetraethylene glycol di(meth)acrylate, polyethylene glycol di(meth)acrylate, 1,4-butanediol di(meth)acrylate, 1,6-hexanediol di(meth)acrylate, neopentyl glycol di(meth)acrylate, tris(2-hydroxyethyl) isocyanurate di(meth)acrylate, bis(hydroxymethyl)tricyclodecane di(meth)acrylate, di(meth)acrylate of the diol which is an addition compound of ethylene oxide or propylene oxide to bisphenol A, di(meth)acrylate of the diol which is an addition compound of ethylene oxide or propylene oxide of hydrogenated bisphenol A, epoxy (meth)acrylate prepared by the addition of (meth)acrylate to diglycidyl ether of bisphenol A, and diacrylate of polyoxyalkylene-addition bisphenol A can be given.

As commercially available products of these polyfunctional monomers, Yupimer UV SA1002, SA2007 (manufactured by Mitsubishi Chemical Corp.), Viscoat #195, #230, #215, #260, #335HP, #700, #540 (manufactured by Osaka Organic Chemical Industry, Ltd.), Light Acrylate 4EG-A, 9EG-A, NP-A, DCP-A, BP-4EA, BP-4PA (manufactured by Kyoeisha Chemical Co., Ltd.), KAYARAD MANDA, HX-220, HX-620, R-551, R-712, R-604, R-684 (manufactured by Nippon Kayaku Co., Ltd.), Aronix M208, M210, M215, M220, M240 (manufactured by Toagosei Co., Ltd.), and Ripoxy VR-77, VR-60, VR-90 (manufactured by Showa Highpolymer Co., Ltd.), can be given.

The photo curable resin composition of the present invention is cured by radioactive rays. Here, radioactive rays mean, for example, ultraviolet rays, infrared ray, visible rays, and ionizing radiation such as X-rays, electron beams, α-rays, β-rays, and γ-rays. Therefore, the composition must contain the photopolymerization initiator of the component (C) and, as required, a photosensitizer may be added. Any photopolymerization initiators can be used in the present invention inasmuch as such photopolymerization initiators can generate radicals and initiate polymerization by irradiation of light. Examples include acetophenone, acetophenone benzyl ketal, 1-hydroxycyclohexylphenyl ketone, 2,2-dimethoxy-2-phenylacetophenone, xanthone, fluorenone, benzaldehyde fluorene, anthraquinone, triphenylamine, carbazole, 3-methylacetophenone, 4-chlorobenzophenone, 4,4'-dimethoxybenzophenone, 4,4'-diaminobenzophenone, Michler's ketone, benzoin propyl ether, benzoin ethyl ether, benzyl methyl ketal, 1-(4-isopropylphenyl)-2-hydroxy-2- methylpropan-1-one, 2-hydroxy-2- methyl-1-phenylpropan-1-one, thioxanethone, diethylthioxanthone, 2- isopropylthioxanthone, 2-chlorothioxanthone, 2-methyl-1-[4-(methylthio)phenyl]-2-morpholino-propan-1-one, 2,4,6-trimethylbenzoyl diphenylphosphine oxide, bis-(2,6-dimethoxybenzoyl)-2,4,4-trimethylpentyl phosphine oxide.

As commercially available products of photopolymerization initiators, for example, Irgacure 184, 369, 651, 500, 819, 907, 784, 2959, CGI1700, CGI1750, CGI1850, Darocur l116, 1173 (manufactured by Ciba Specialty Chemicals), Lucirin TPO, TPO-L (manufactured by BASF), Ubecryl P36 (manufactured by UCB) can be given.

When the resin composition of the present invention is cured, a thermopolymerization initiator can be used jointly as required. Peroxides and azo compounds can be given as examples of desirable thermopolymerization initiators. As specific examples, benzoyl peroxide, t-butyl peroxybenzoate and azobisisobutyronitrile can be given. The optimum amount of photopolymerization initiators incorporated to cure the resin composition of the present invention is from 0.01 to 10 wt%, and preferably from 0.5 to 7 wt% in the total amount of the composition. If more than 10 wt%, the curing characteristics of the composition, mechanical and optical characteristics of the cured products, and handling performance of the composition may be adversely affected; if less than 0.01 wt%, the curing speed may be retarded. In addition to the above components, other curable oligomers or polymers may be incorporated in the resin composition of the present invention to the extent that the characteristics of the resin composition are not adversely affected. As examples of such other curable oligomers or polymers, polyurethane (meth)acrylate, polyester (meth)acrylate, epoxy (meth)acrylate, polyamide (meth)acrylate, siloxane polymers having a (meth)acryloyloxy group, reactive polymers obtained by the reaction of a copolymer of glycidyl methacrylate and another polymerizable monomer and (meth)acrylic acid can be given. Moreover, in addition to the above-mentioned components various additives, for example antioxidants, UV absorbers, light stabilizers, silane coupling agents, coating surface improvers, thermal polymerization inhibitors, leveling agents, surfactants, coloring matters, preservatives, plasticizers, lubricants, solvents, fillers, aging preventives, wettability improvers can be added as required. As examples of the antioxidants, Irganox 1010, 1035, 1076, 1222 (manufactured by Ciba Specialty Chemicals Co., Ltd.), Antigene P, 3C, FR, Sumilizer (manufactured by Sumitomo Chemical Industries Co., Ltd.) can be given. As examples of the UV absorbers, Tinuvin P, 234, 320, 326, 327, 328, 329, 213 (manufactured by Ciba Specialty Chemicals Co., Ltd.), Seesorb 102, 103, 501, 202, 712, 704 (manufactured by Shipro Kasei K.K.) can be given. As examples of the light stabilizers, Tinuvin 292, 144, 622LD (manufactured by Ciba Specialty Chemicals Co., Ltd.), Sanol LS770 (manufactured by Sankyo Co., Ltd.), Sumisorb TM-061 (manufactured by Sumitomo Chemical Industries Co., Ltd.) can be given. As examples of the silane coupling agents, g-aminopropyltriethoxy silane, g-mercaptopropyltrimethoxysilane, g-methacryloxypropyltrimethoxysilane and commercially available products for example SH6062, 6030 (manufactured by Dow Corning Toray Silicone Co., Ltd.), and KBE903, 603, 403 (manufactured by Shin-Etsu Chemical Co., Ltd.) can be given. As examples of coating surface improvers, silicone additives such as dimethyl siloxane polyether can be given. As examples of commercially available products, DC-57, DC-190 (manufactured by Dow Corning Co.), SH-28PA, SH-29PA, SH-30PA, SH-190 (manufactured by Dow Corning Toray Silicone Co., Ltd.), KF351, KF352, KF353, KF354 (manufactured by Shin-Etsu Chemical Co., Ltd.), L-700, L-7002, L-7500, FK-024-90 (manufactured by Nippon Unicar) can be given. The resin composition of the present invention can be manufactured by blending the above-mentioned components by a conventional method. Viscosity of the resin composition of the present invention manufactured as described above is usually from 200 to 5,000 mPa.sec/25°C, and preferably from 500 to 4,000 mPa.sec/25°C. If the viscosity is more than 5,000 mPa.sec/25°C, coating unevenness and crinkles may be produced and transfer of prism patterns is impaired resulting in lenses which can exhibit only insufficient performance. If less than 200 mPa.sec/25°C on the other hand, it is difficult to control the lens thickness and, therefore, to manufacture homogeneous prisms with a uniform thickness.

Useful cured products are for example optical parts. Examples of optical parts are lens materials, for example opthalmic lenses, pick-up lenses for CD or DVD, lenses for cameras, telescopes. Further examples of optical parts are a lens sheet, for example prism lens sheet for LCD back light, a fresnel lens or a lenticular lens for protection TV and light wave guide.

Preferably, the cured products, or shaped articles are prepared by curing the resin composition of the present invention by radioactive rays.

Typically the shaped articles of this invention are prepared by pouring or filling a mold master with the oligomeric composition, exposing the resulting cast composition to actinic radiation to rapidly cure the same, and removing from said mold master the resulting shaped article which has a surface bearing microstructure replicated from the mold master (see e.g. US 4,576,850).

The particular mold master used in replication will depend on the type of shaped article to be made. For purposes of making optical lenses, e.g. ophtalmic lens blanks, having a surface with an optical finish, the mold master can be of transparent (e.g. "Pyrex") glass, such masters being commercially available. For purposes of making diffraction gratings, e.g., spectral filters, light collectors, and decorating decals, the mold master can be made of metal with the diffraction pattern thereon made by mechanical ruling or holographically.

For cube-corner sheeting, linear Fresnel lenses, and other shaped articles having raised or indented microstucture-bearing surfaces, mold masters can be used which are made of plastic, e.g. acrylonitrilebutadienestyrene, or preferably (for mass production of such replicated articles) made of metal fabricated for example directly from a suitable metal by engraving, hobbing, assembling as a bundle of a plurality of metal parts machined in the desired configuration, or other mechanical means or by electroforming.

The refractive index at 25°C of the cured products is usually 1.57 or more, and preferably 1.58 or more, and the temperature at which the loss tangent determined from the oscillation frequency at 10 Hz which is measured by dynamic viscoelasticity indicates the maximum value ("glass-transition temperature") is 80°C or more preferably 85°C or more. If the refractive index is less than 1.57, the backlight of liquid crystal display prepared by using the lens sheet which is produced from the resin composition of the present invention cannot exhibit sufficient face brightness. If the glass-transition temperature is less than 80°C, the lens shape may be deformed when used at a high temperature and the lens cannot exhibit satisfactory performance. In addition, because of the same reasons as above, to ensure excellent characteristics at high temperatures the cured products should have a dynamic modulus of elasticity at 100°C of 5*10⁶ N/m² or more, and preferably 1.0*10⁷ N/m² or more. The storage modulus of elasticity here is the modulus of elasticity when periodic oscillation of 10 Hz was given in the dynamic viscoelasticity measurement.

### Examples

The present invention will now be described in detail by way of examples, which should not be construed as limiting the present invention.

In the following description, "parts" means "parts by weight".

### Examples 1-3 and Comparative Examples 1-3

A reaction vessel equipped with a stirrer was charged with 35 parts of the compound A-1 (the compound of the formula (1), wherein R¹ and R² are hydrogen atoms, m=1 and n=1, and X is a bromine atom.) which is the component (A), 10 parts of tris(2-hydroxyethyl) isocyanurate triacrylate and 5 parts of dipentaerythritol hexacrylate which are the component (B), 40 parts of 2,4,6-tribromophenoxyethyl acrylate which is the component (D), 10 parts of acryloylmorpholine, and 3 parts of 1-hydroxycyclohexylphenyl ketone which is the component (C). The mixture was stirred for 3 hours while controlling the temperature at 50-60°C to obtain a liquid curable resin composition with a viscosity of 650 mPa.sec/25°C.

### Synthetic Example 1

### Preparation of the component (A) urethane acrylate

A reaction vessel equipped with a stirrer was charged with 87.85 parts of A-1, 12.04 parts of 1,3-xylylene diisocyanate, and 0.03 part of 2,6-di-t-butyl-p-cresol. The mixture was cooled at 5-10°C. When the temperature was lowered to 10°C or less while stirring, 0.08 part of di-n-butyl tin dilaurate was added. After stirring for one hour while controlling the liquid temperature at 20-30°C, the mixture was stirred for a further 3 hours at 50-60°C. The reaction was terminated when the residual isocyanate was reduced to 0.1 wt% or less. The resulting urethane acrylate was designated as A-2.

For Examples 2 and 3 and Comparative Example 1-3, the components of the compositions shown in Table 1 were filled into the reaction vessel and the liquid resin compositions were obtained in the same manner.

### Methods of evaluation

Test specimens were prepared using the liquid curable resin compositions obtained in the above-mentioned examples according to the method described below to measure the viscosity, refractive index, transparency, and glass-transition temperature according to the following measuring methods.

### Measurement of viscosity:

The viscosity at 25°C was measured using a rotational viscometer according to JIS K7117.

### Preparation of test specimens:

The liquid curable resin composition was applied to a glass plate to produce a coating with a thickness of about 200 mm using a 15 mill applicator bar and irradiated with ultraviolet rays at a dose of 1.0 J/cm² in air to obtain a cure film. Then, the cure film was peeled off from the glass plate and conditioned at a temperature of 23°C and a relative humidity of 50% for 24 hours to obtain a test specimen.

### Measurement of refractive index:

The refractive index at 25°C of the test specimen prepared above was measured using an Abbe refractometer.

### Measurement of glass-transition temperature and storage modulus of elasticity:

The glass-transition temperature of the test specimen was measured using a compulsory resonance oscillation-type dynamic viscoelasticity measurement apparatus. The loss tangent and the temperature change of storage modulus of elasticity were measured while oscillating the test specimen at a frequency of 10 Hz and heating the test specimen at a rate of 3°C/minute. The temperature at which the loss tangent showed the maximum value as mentioned above was defined as the glass-transition temperature (Tg).

### Measurement of transparency:

Transmittance of the test specimen up to 400-700 cm-1 was measured using a spectrophotometer. In this wavelength range, when the transmittance was 95% or more, transparency was judged to be excellent and use as a lens sheet was no problem, in which case the test specimen was indicated as "○" in Table 1; if the transmittance was 95% or less, the test specimen was judged to cause a problem and indicated as "X" in Table 1.

### Substrate adhesive properties:

Using a 15 mil applicator bar the liquid curable resin composition was applied to a PET film which was previously treated to improve the adhesion properties to produce a coating with a thickness of about 100 mm. The coating was irradiated with ultraviolet rays at a dose of 1.0 J/cm² under nitrogen to obtain a cure film. The adhesive properties with substrates was evaluated by a cross-cut tape test according to JIS K5400. The test specimens in which no square was peeled off were rated as "○", which some squares were peeled off were rated as "△", and all squares were peeled off were rated as "X". In Table 1, the various components are indicated by the following abbreviations.

### Component (A):

A-1: The compound of the formula (1), wherein R1 and R2 are hydrogen atoms, m=1 and n=1, and X is a bromine atom. A-2: An addition-polymerization compound of 2 mois of A-1 and 1 mol of 1,3-xylylene diisocyanate

### Component (B):

B-1: Tris(2-hydroxyethyl)isocyanurate triacylate
B-2: Dipentaerythritol hexacrylate
B-3: Trimethylolpropane triacrylate

### Component (C):

C-1: 1-Hydroxycyclohexyl phenyl ketone

### Component (D):

D-1: Phenoxyethyl acrylate
D-2: 2,4,6-Tribromophenoxyethyl acrylate
D-3: Acrylate of p-cumylphenol reacted with ethylene oxide
(Mn=310)

### Other components:

E-1: Diacrylate of diol which is the addition compound of ethylene oxide of bisphenol A (Mn=510)
E-2: Acryloylmorpholine (Mn indicates a polystyrene-reduced number average molecular weight.)

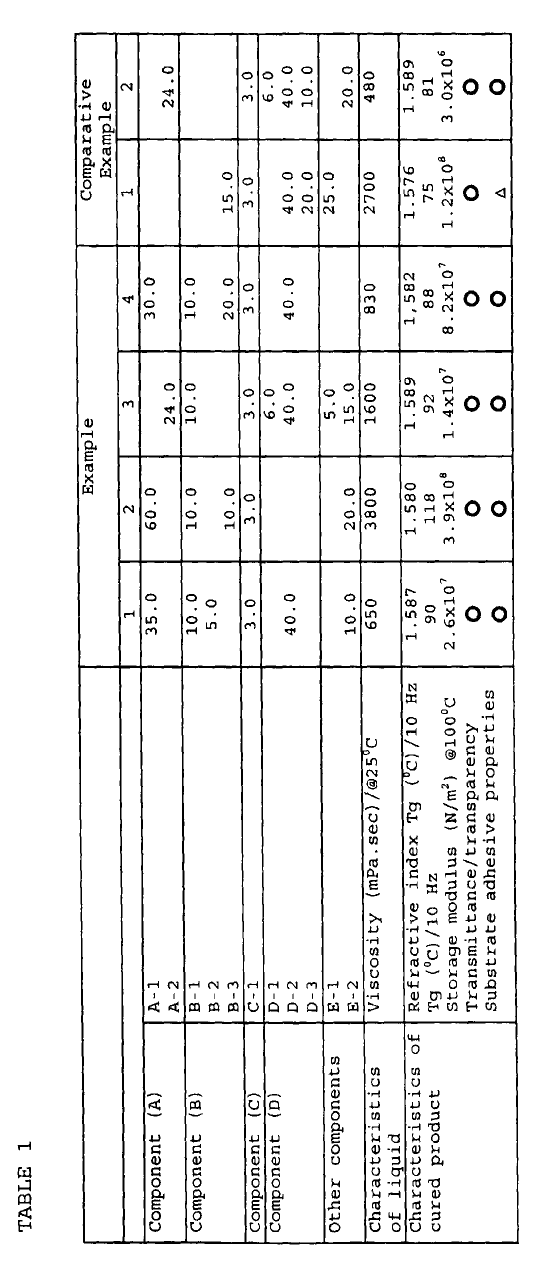

As can be seen from Table 1, the cured products obtained from the photo curable resin composition of the present invention in which the components (A), (B), and (C) are incorporated exhibited a higher glass-transition temperature and higher storage modulus of elasticity at 100°C than the cured products obtained from the compositions in which the components (A) and (C) are incorporated. It is thus clear that the cured products made from the composition of the present invention is useful as optical parts for a backlight for liquid crystal displays.

## Claims

1. A photo curable resin composition comprising,
(A) a compound shown by the following formula (1), 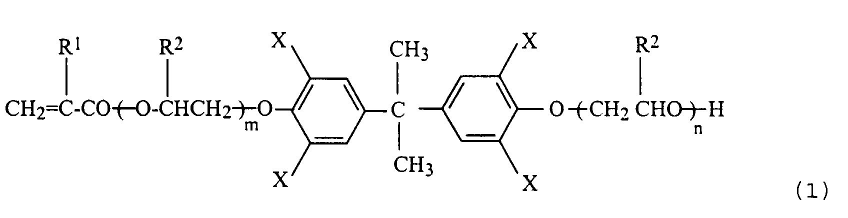 wherein R¹ and R² individually represent a hydrogen atom or methyl group, m and n are integers of which the total is 0 or 1-6, and X represents a bromine or chlorine atom, or a urethane (meth)acrylate obtained by the reaction of the compound of the formula (1) and an organic isocyanate,
(B) a (meth)acrylate which possesses 3 or more (meth)acryloyl groups in the molecule, and
(C) a photopolymerization initiator.

2. The photo curable resin composition according to claim 1, wherein R¹ and R² are hydrogen, X is Br and (m+n) = 2.

3. The photo curable resin composition according to anyone of claims 1 or 2, wherein the organic isocyanate is a diisocyanate.

4. The photo curable resin composition according to any of claims 1-3, wherein compound A is present in an amount from 3-75 wt%, and component B is present in an amount of 5-40 wt%.

5. The photo curable resin composition according to anyone of claims 1-4, wherein the viscosity of the resin composition is between 500 to 5000 mPa.sec.

6. The photo curable resin composition according to anyone of claims 1-5, wherein it further comprises a monofunctional (meth)acrylate shown by the following formula (2), 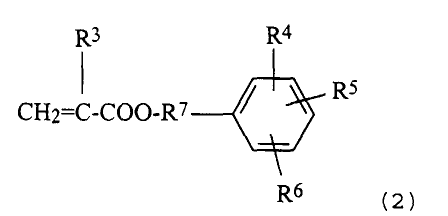 wherein R³ represents a hydrogen atom or a methyl group, R⁴-R⁶ individually represent a hydrogen atom, a bromine atom, an alkyl group having 1-10 carbon atoms, a phenyl group, or a group C₆H₅-C(CH₃)₂-, R⁷ represents a group (CH₂CH₂O)ₚ-, -(CH(CH₃)CH₂O)_{q}-, or -CH₂CH(OH)CH₂O- (wherein p and q are individually an integer from 1-10).

7. Use of photo curable resin composition according to any of claims 1-6, for the manufacture of optical parts.

8. Optical parts comprising prism lens sheets, fresnel lenssheets or lenticular lens sheets, characterized in that they contain cured products prepared from photo curable resin compositions according to any of claims 1-6

9. Optical parts according to claim 8, wherein the the cured products made from the photo curable resin composition as defined in any of claims 1-7 have a refractive index of 1.57 or more at 25°C.

10. Optical parts according to anyone of claims 8-9, wherein the cured products made from the photo curable resin composition have a glass-transition temperature of 80°C or higher and storage modulus of elasticity of 5*10⁶ Pascal or more at 100°C.

11. Method of making optical parts by filling a mold master with the photo curable resin composition as defined in anyone of claims 1-6, exposing the cast composition to actinic radiation and removing the shaped article from said mold master.

12. Apparatus comprising optical parts as claimed in anyone of claims 8-10.
